# EUROPÄISCHE PATENTSCHRIFT

(11) **EP 2 780 972 B1**
(45) Veröffentlichungstag und Bekanntmachung des Hinweises auf die Patenterteilung: **21.10.2015**
(21) Anmeldenummer: 12788177.9
(22) Anmeldetag: 12.11.2012
(51) Int. Cl.: G01K 15/00, H01M 10/42, H01M 10/48, G01K 13/00, G01R 31/36, H01M 10/04, H01M 2/20

(54) **BATTERIE MIT EINER BATTERIEZELLE MIT EXTERNEM UND INTEGRIERTEM TEMPERATURSENSOR UND VERFAHREN ZUM BETRIEB DER BATTERIE**
BATTERY COMPRISING A BATTERY CELL WITH AN EXTERNAL AND AN INTEGRATED TEMPERATURE SENSOR, AND A METHOD FOR OPERATING SAID BATTERY
BATTERIE COMPORTANT UN ÉLÉMENT DE BATTERIE POURVU D'UN CAPTEUR DE TEMPÉRATURE EXTERNE ET D'UN CAPTEUR DE TEMPÉRATURE INTÉGRÉ ET PROCÉDÉ POUR FAIRE FONCTIONNER LA BATTERIE

(30) Priorität: 18.11.2011 DE 102011086616; 19.06.2012 DE 102012210262
(43) Veröffentlichungstag der Anmeldung: 24.09.2014
(73) Patentinhaber: Robert Bosch GmbH, 70442 Stuttgart (DE); Samsung SDI Co., Ltd., Yongin-si, Gyeonggi-do 446-577 (KR)
(72) Erfinder: REIHLEN, Eckart, 70192 Stuttgart (DE); SCHNEIDER , Jens, 71229 Leonberg (DE); HEUBNER , Anne, 71672 Marbach (DE); PANKIEWITZ , Christian, 70378 Stuttgart (DE); HEINRICI , Fabian, 70195 Stuttgart (DE); FISCHER , Peter, 70839 Gerlingen (DE)
(74) Vertreter: Bee, Joachim
(86) Internationale Anmeldenummer: PCT/EP2012/072397
(87) Internationale Veröffentlichungsnummer: WO 2013/072279

(56) Entgegenhaltungen:
- WO-A1-2011/067556
- DE-A1-102008 046 510
- DE-A1-102010 007 076
- KOFI A A MAKINWA ET AL: "A CMOS Temperature-to-Frequency Converter With an Inaccuracy of Less Than (3) From to 105", IEEE JOURNAL OF SOLID-STATE CIRCUITS, IEEE SERVICE CENTER, PISCATAWAY, NJ, USA, Bd. 41, Nr. 12, 1. Dezember 2006 (2006-12-01), Seiten 2992-2997, XP011150730, ISSN: 0018-9200, DOI: 10.1109/JSSC.2006.884865 in der Anmeldung erwähnt

## Beschreibung

Die vorliegende Erfindung betrifft eine Batterie mit einer Batteriezelle, bevorzugt eine Lithium-Ionen-Batteriezelle, in welcher ein externer und ein batteriezellinterner Temperatursensor angeordnet sind.

### Stand der Technik

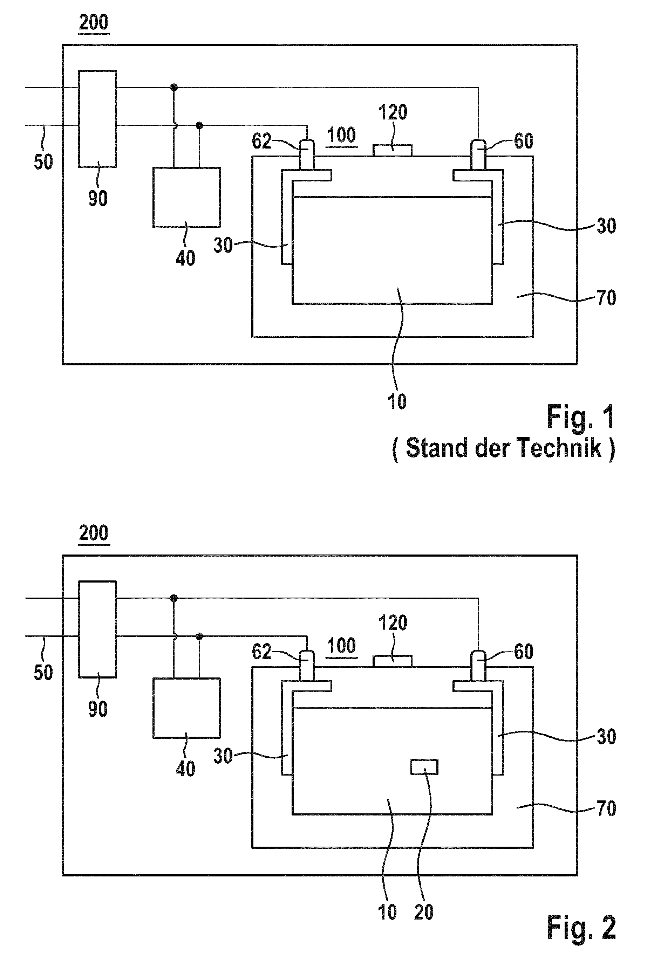

Es zeichnet sich ab, dass in Zukunft sowohl bei stationären Anwendungen als auch bei Fahrzeugen wie Hybrid- und Elektrofahrzeugen in immer größerem Umfang Batteriesysteme zum Einsatz kommen werden. Insbesondere werden vermehrt Batterien als Traktionsbatterien für den Einsatz in Hybrid- und Elektrofahrzeugen verwendet und somit für die Speisung elektrischer Antriebe eingesetzt. Figur 1 zeigt eine solche Batterie 200 des Standes der Technik. Sie umfasst eine Batteriezelle 100 mit einem Gehäuse 70 und einem Zellkern, der eine Elektrodenanordnung 10 zur Erzeugung von Energie umfasst.

Zum Betrieb der Batterie 200 werden mathematische Batteriemodelle verwendet. Dabei hängen jedoch Innenwiderstände und Zeitkonstanten des dynamischen Batteriezellverhaltens unter Last stark von der Temperatur im Zellkern ab, in dem die chemischen Reaktionen stattfinden. Aufgrund von lastbedingter Wärmeproduktion kann sich die Temperatur im Zellkern schnell ändern.

Nach dem Stand der Technik erfolgt die Temperaturmessung an Batteriezellen mittels Temperatursensoren, die meist auf dem Gehäuse angebracht sind. So offenbart DE 199 61 311 A1 einen Temperatursensor, der mittels einer Batterieklemme an der Batterie von außen befestigt wird. Die temperaturabhängigen Batteriemodellparameter werden dann offline oder online auf die Gehäusetemperatur abgebildet. Jedoch entspricht die Gehäuseaußentemperatur weder der Kerntemperatur im Inneren des Gehäuses an der Elektrodenanordnung noch ist sie eindeutig mit dieser verknüpft. Somit wird eine Änderung der Kerntemperatur auf dem Batteriezellgehäuse wegen thermischer Übergangswiderstände innerhalb der Zelle und nach außen hin verzögert oder gar nicht gemessen.

Die ungenaue Erfassung der aktuellen Temperatur im Zellkern führt in Konsequenz zu Ungenauigkeiten in temperaturabhängigen Batteriemodellen des Betriebszustandes der Batterie. Die Batteriemodelle können sowohl im Batteriesteuergerät zur Überwachung und Steuerung des Betriebes der Batterie als auch außerhalb der Batterie in einer offline-Simulation Verwendung finden.

Aus der DE 100 56 972 A1 ist eine Batteriezelle bekannt, bei der Sensoren zur Bestimmung der Batterietemperatur in dem Gehäuse einer Batteriezelle angeordnet sind. Die Temperatursensoren sind als Temperaturfühler ausgebildet und über elektrische Leitungen mit dem Außenbereich des Batteriegehäuses verbunden. Der Verbau von üblichen Messfühlern, in denen z. B. eine NTC-Messeinheit in herkömmlicher dreidimensionaler Bauweise enthalten ist, im Inneren der Batteriezelle kann die Zellkerntemperatur zwar erfassen, beeinflusst aber jedoch durch die Erfassungs- und Auswerteeinheiten sowie die Signalleitungen die Wärmeentwicklung und die Wärmeflüsse in der Batterie.

Aus der DE 10 2008 046510 A1 ist eine Einrichtung bekannt, die nach galvanischen Prinzipien arbeitet und ein Verfahren zum Überwachen und Steuern eines elektrischen Betriebszustands der Einrichtung, wobei die Einrichtung mindestens eine galvanische Zelle und ein Betriebsmanagementsystem zum Überwachen und Steuern des elektrischen Betriebszustands der Einrichtung sowie zum Überwachen einer repräsentativen Temperatur der Einrichtung aufweist. Das Betriebsmanagementsystem ist dazu ausgebildet, den elektrischen Betriebszustand in Abhängigkeit von der Temperatur zu steuern.

Ferner offenbaren Makinwa und Snoeij ("A CMOS Temperature-to-Frequency Converter With an Inaccuracy of Less Than +- 0,5°C (3□) From -40°C to 105°C", K. A. A. Makinwa, Martijn F. Snoeij, IEEE Journal of Solid-State Circuits, Vol. 41, No. 12, December 2006, p. 2992-2997) einen Temperatur-zu-Frequenz-Konvertierer, der in einem Standard CMOS-Verfahren implementiert ist.

Des Weiteren kann die Batterie auch eine Kühlung zur Kühlung der Batteriezellen enthalten. Dann kann ein weiterer Temperatursensor in der Kühlung angeordnet sein.

Nach dem Stand der Technik können sowohl der Temperatursensor am Gehäuse als auch der Temperatursensor in der Kühlung eine hohe Genauigkeit bezüglich ihrer absoluten Temperaturmessfähigkeit aufweisen, sind aber bedingt durch die Einbaulage und den Wärmeübertragungsweg träge bei der Erfassung von schnellen Temperaturwechseln innerhalb der Batteriezelle. Dies resultiert in einer verzögerten Wiedergabe eines Temperaturanstiegs im Inneren der Batteriezelle, insbesondere bei sicherheitskritischen, weil sehr schnellen Temperaturanstiegen in Folge eines Kurzschlusses.

### Offenbarung der Erfindung

Erfindungsgemäß wird eine Batterie umfassend mindestens eine Batteriezelle, bevorzugt eine Lithium-Ionen-Batteriezelle, mit einem Gehäuse, in dem eine Elektrodenanordnung angeordnet ist, einem ersten Temperatursensor, der außerhalb des Batteriezellgehäuses angeordnet ist und einem zweiten Temperatursensor, der im Inneren des Batteriezellgehäuses angeordnet ist, vorgeschlagen. Dabei ist die Temperaturdynamik des zweiten Temperatursensors höher als die Temperaturdynamik des ersten Temperatursensors.

Erfindungsgemäß werden die Ausgangssignale des zweiten Temperatursensors mittels der Stromsammler der Elektrodenanordnung über Terminals aus der Batteriezelle herausgeführt.

Vorteilhafterweise kann die Batterie mittels des zweiten Temperaturfühlers schneller auf sicherheitskritische Zustände reagieren. Temperaturen können dort erfasst werden, wo die chemischen Reaktionen stattfinden, also innerhalb des Batteriezellengehäuses, ohne jedoch die Wärmeentwicklung und Temperatur durch Signalleitungen, Erfassungs- oder Auswerteeinheiten zu beeinflussen. Somit kann durch die Erfassung der Gehäuseinnentemperatur ein Batteriemodell im Batteriesteuergerät genauer parametriert und zu Simulations- sowie Zustandserkennungs- und Prädiktionszwecken besser ausgewertet werden.

Die erfindungsgemäße Batterie umfasst bevorzugt mehrere in Reihe angeordnete Batteriezellen, wobei mehrere der Batteriezellen einen ersten Temperatursensor, der außerhalb der jeweiligen Batteriezellen angeordnet ist, aufweisen und mindestens eine der Batteriezellen einen zweiten Temperatursensor aufweist, der im Inneren des Gehäuses der betreffenden Batteriezelle angeordnet ist.

Allein durch die Verwendung eines Temperatursensors kann die Sicherheit der Batterie erhöht werden, da ein sicherheitskritischer Zustand schneller erfasst wird.

Die Batterie umfasst bevorzugt ferner ein Batteriesteuergerät, welches dazu eingerichtet ist, die Temperaturen der ersten und zweiten Temperatursensoren zu empfangen und zu verarbeiten, und eine Batterietrenneinheit, die dazu eingerichtet ist, bei Überschreiten eines Schwellenwertes der Temperaturdynamik des zweiten Temperatursensors und/oder bei Überschreiten des Temperaturwertes des zweiten Temperatursensors die Batterie von einem angeschlossenen Stromkreis zu trennen.

Ferner ist das Batteriesteuergerät zusätzlich oder auch alternativ dazu eingerichtet, den zweiten Temperatursensor bei thermischem Gleichgewicht, also nach einer längeren Ruhephase der Batterie, mittels des ersten Temperatursensors zu kalibrieren.

Auch kann ein dritter Temperatursensor in einer Kühlung der Batteriezellen in der Batterie angeordnet sein.

Der erste Temperatursensor ist bevorzugt ein Temperaturfühler, beispielsweise ein Heißleiter (NTC) oder ein Kaltleiter (PTC). Diese weisen vorteilhafterweise eine hohe Genauigkeit des Absoluttemperaturwertes auf.

Der zweite Temperatursensor ist bevorzugt als ein Differentialtemperatursensor ausgebildet. Die Erfindung ermöglicht eine dynamische Erfassung von Temperaturwechseln in der Zelle (ΔT/dt). Bevorzugt liegen die Dynamikwerte ΔT/dt des zweiten Temperatursensors im Inneren einer Batteriezelle zwischen 0,5 K/min und 5 K/min. Die Dynamikwerte des ersten Temperatursensors liegen dann unterhalb des Wertebereichs des zweiten Temperatursensors.

Der zweite Temperatursensor ist bevorzugt in einer integrierten Schaltung in einem Mikrochip integriert. Die Integrierbarkeit im Inneren des Gehäuses ermöglicht eine kleine Bauweise, welche kostengünstig und robust gegen Einflüsse von außen ist.

Der zweite Temperatursensor umfasst bevorzugt einen CMOS-Oszillator, also einen thermischen Oszillator, der unter Verwendung der CMOS-Technologie in einer integrierten Schaltung realisiert ist. Bei komplementären Metall-Oxid-Halbleitern ("CMOS") werden sowohl p-Kanal- als auch n-Kanal-Feldeffekttransistoren auf einem gemeinsamen Substrat verwendet. Der Vorteil dieses Aufbaus ist, dass er direkt in eine anwendungsspezifische integrierte Schaltung (ASIC) integriert werden kann und ein temperaturproportionales Frequenzsignal liefert. Bevorzugt umfasst der elektrothermische Oszillator eine Thermosäule mit Thermoelementen. Thermoelemente habe gegenüber Transistoren den Vorteil, dass sie keinen Offset haben und frei von 1/f Rauschen sind.

In einem anderen Ausführungsbeispiel umfasst der zweite Temperatursensor einen temperaturabhängigen bipolaren Transistor. Mit anderen Worten umfasst die Erfindung in einem Mikrochip integrierte Temperatursensoren auf Basis der Temperaturabhängigkeit der Siliziumdiodenkennlinie, wie z. B. Bandgap-Temperatursensoren. Auch hier kann der zweite Temperatursensor direkt in eine anwendungsspezifische integrierte Schaltung (ASIC) integriert werden.

Das quasi-digitale Ausgangssignal des zweiten Temperatursensors wird in einer Ausgestaltung der Erfindung mittels Stromleitungskommunikation ("power line communication") aus dem Gehäuse geführt. Der Sensor lässt sich dadurch in eine Zelle integrieren, ohne dass zusätzliche Stromleitungen nach außen durch die Gehäusewand notwendig werden.

Die Elektrodenanordnung besteht bevorzugt aus einer Wicklung von einer ersten und einer zweiten Elektrode mit einem Separator dazwischen und der Temperatursensor ist in einem Ausführungsbeispiel direkt an der Wicklung angeordnet.

Die Elektrodenanordnung ist bevorzugt mit mindestens einem Stromsammler verbunden, der den Strom der Elektrodenanordnung aus dem Gehäuse herausführt, und der Temperatursensor ist bevorzugt mit dem Stromsammler thermisch gekoppelt, noch bevorzugter direkt auf dem mindestens einen Stromsammler angeordnet. Der Temperatursensor ist in einer bevorzugten Ausgestaltung der Erfindung mit der Elektrodenanordnung zu seiner Energieversorgung elektrisch verbunden. Da der Stromsammler direkt mit dem Zellwickel gekoppelt ist und den Strom aus der Elektrodenanordnung abgreift, kann der Temperatursensor die Temperatur am Zellwickel direkt bestimmen und gleichzeitig den Strom für seinen Betrieb aus dem Zellwickel beziehen.

Ferner wird ein Kraftfahrzeug mit einer erfindungsgemäßen Batteriezelle vorgeschlagen, wobei die Batteriezelle mit dem Antrieb des Kraftfahrzeuges verbunden ist.

Zudem wird ein Verfahren zum Betrieb einer Batterie vorgeschlagen, welches die Schritte Bestimmen der Temperatur außerhalb der Batteriezellen durch den mindestens einen ersten Temperatursensor, Bestimmen der Änderung des Temperaturanstiegs des zweiten Temperatursensors, und Trennen der Batterie von einem angeschlossenen Stromkreis bei Überschreiten eines Schwellwertes des Temperaturanstiegs des zweiten Temperatursensors, und/oder bei Überschreiten eines Schwellwertes der Temperatur des zweiten Temperatursensors umfasst.

Das Verfahren kann ferner in Ruhephase der Batterie die Temperaturen des ersten Temperatursensors und des zweiten Temperatursensors bestimmen und bei Abweichen der Temperaturwerte den zweiten Temperatursensor mithilfe der Temperatur des ersten Temperatursensors kalibrieren.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 eine Batterie des Standes der Technik,
Figur 2 eine erfindungsgemäße Batterie mit einer Batteriezelle und einem Temperatursensor im Inneren des Batteriezellengehäuses,
Figur 3 eine erfindungsgemäßes Batterie mit einer Kühlung und einem dritten Temperatursensor, und
Figur 4 eine Ausführung eines thermischen Oszillators.

### Ausführungsformen der Erfindung

In der Figur 1 ist eine Batterie 200 des Standes der Technik gezeigt. Die Batterie 200 umfasst ein Batteriesteuergerät 40 und eine Batteriezelle 100 mit einem Gehäuse 70. Im Inneren des Gehäuses 70 ist ein Zellkern, eine Elektrodenanordnung 10 angeordnet. Die Elektrodenanordnung 10 umfasst bevorzugt eine erste, positive und eine zweite, negative Elektrode, die durch einen Separator getrennt sind. Die Elektroden sind bevorzugt mit dem Separator dazwischen gewickelt. Die Elektrodenanordnung 10 wird von Stromsammlern 30 an zwei gegenüberliegenden Seiten kontaktiert. Der eine Stromsammler 30 kontaktiert die erste Elektrode 11, der zweite Stromsammler 30 kontaktiert die zweite Elektrode 12. Die Stromsammler 30 sind mit einem ersten und einem zweiten Terminal 60, 62 verbunden. Die Terminals 60, 62 führen den Strom aus dem Gehäuse 70 der Batteriezelle 100 heraus. Über elektrische Verbindungsleitungen 50 ist das Batteriesteuergerät 40 mit den Terminals 60, 62 der Batteriezelle 100 verbunden. Das Batteriesteuergerät 40 steuert den Betrieb der Batterie 200, wie Lade- und Entladevorgänge. Im Batteriesteuergerät 40 ist bevorzugt ein Batteriemodell implementiert. Es dient der Überwachung der Batterie 200. Ferner weist die Batterie 200 eine Batterietrenneinheit 90 auf, die bei sicherheitskritischen Zuständen die Batterie 200 von einem externen Stromkreis (nicht gezeigt) abtrennt.

Figur 2 zeigt nun eine erfindungsgemäße Batterie 200. Sie entspricht im Wesentlichen dem Aufbau der Batterie 200 des Standes der Technik in Figur 1, weist aber einen zweiten Temperatursensor 20 im Inneren der Batteriezelle 100 auf. Die erfindungsgemäße Batterie 200 kann aber auch mehrere Batteriezellen 100 aufweisen, die bevorzugt nebeneinander angeordnet sind.

Der zweite Temperatursensor 20 wandelt Temperaturen in Frequenzen um, liefert also ein temperaturproportionales Frequenzsignal. Er umfasst einen thermischen Oszillator, bevorzugt, aber nicht beschränkend einen thermischen Oszillator, der mittels CMOS-Technologie auf einem Mikrochip in einer anwendungsspezifischen integrierten Schaltung integriert ist.

Der thermische Oszillator ist bevorzugt ein CMOS-Temperatur-zu-Frequenz-Wandler, wie offenbart durch Makinwa und Snoeij ("A CMOS Temperature-to-Frequency Converter With an Inaccuracy of Less Than +- 0,5°C (3σ) From -40°C to 105°C", K. A. A. Makinwa, Martijn F. Snoeij, IEEE Journal of Solid-State Circuits, Vol. 41, No. 12, December 2006, p. 2992-2997).

Erfindungsgemäß kann durch diesen Aufbau das quasi-digitale Ausgangssignal einfach über schon bestehende Strompfade nach außen aus dem Batteriegehäuse geführt werden. Es sind keine zusätzlichen Durchführungen durch das Gehäuse für Stromleitungen notwendig.

Alternativ kann aber auch ein auf der Bipolartechnik basierender Ansatz benutzt werden. Dann kann das Ausgangssignal, bevorzugt die Spannung, zweckmäßig umgewandelt digitalisiert werden.

Besonders zweckmäßig ist es beispielsweise, den zweiten Temperatursensor 20 wie in Figur 2 direkt am Zellwickel 10 zu platzieren. So kann die Elektrodentemperatur direkt gemessen werden und gleichzeitig der zweite Temperatursensor 20 mit Strom versorgt werden. Er ist dann mit der ersten und zweiten Elektrode elektrisch verbunden.

In einer weiteren Ausgestaltung kann der zweite Temperatursensor 20 auch direkt auf mindestens einem der Stromsammler 30 des Zellwickels 10 platziert werden. Die Stromsammler 30 weisen üblicherweise eine hohe thermische Leitfähigkeit auf, sind aus Metall und können somit die Zellwickeltemperatur an den zweiten Temperatursensor 20 gut weiterleiten.

Der zweite Temperatursensor 20 im Inneren des Gehäuses 70 kann auch von außen über die Terminals 60, 62 mit Strom versorgt werden.

Die gemessene zweite Temperatur wird erfindungsgemäß auf die vorhandenen Stromleitungspfade (Terminal-Stromsammler-Elektrodenanordnung) im Inneren der Batterie aufmoduliert. Von dort aus kann dann die Temperatur an das Batteriesteuergerät 40 über Stromleitungen 50 übermittelt werden. Die Temperaturinformation kann kapazitiv und induktiv durch Einkopplung der Oszillationen des zweiten Temperatursensors 20 auf die Stromleitungspfade aus dem Gehäuse 70 herausgeführt werden. Die Schwingungen werden außerhalb der Batteriezelle 100 mit einem Mittel zur Auskopplung von Schwingungen (nicht gezeigt) wieder ausgekoppelt und im Batteriesteuergerät 40 im dort implementierten Batteriemodell verwendet.

Dies kann online, also während des Betriebs der Batteriezelle 100 geschehen, aber auch offline, im Ruhezustand der Batteriezelle 100. Im letzteren Fall wird der zweite Temperatursensor 20 dann von außen mit Energie beaufschlagt.

Im Batteriesteuergerät 40 wird ein an den jeweiligen Typ der Batteriezelle 100 angepasstes und parametriertes Zellmodell eingesetzt. Der gemessene Strom fließt normalerweise zusammen mit der gemessenen Temperatur als Eingangsgröße in dieses Modell, das die daraus resultierende Spannung simuliert und sie mit der gemessenen Spannung vergleicht, um Modellparameter nachzujustieren, den Ladezustand zu bestimmen, Prädiktionen für Strom oder Leistung bereitzustellen und vieles mehr.

Wird nun entweder online oder offline, bevorzugt in beiden Anwendungsfällen, der erfindungsgemäße Temperaturmesswert aus dem Zellkern eingesetzt, lässt sich das dynamische Verhalten der Zelle signifikant besser berechnen und vorhersagen.

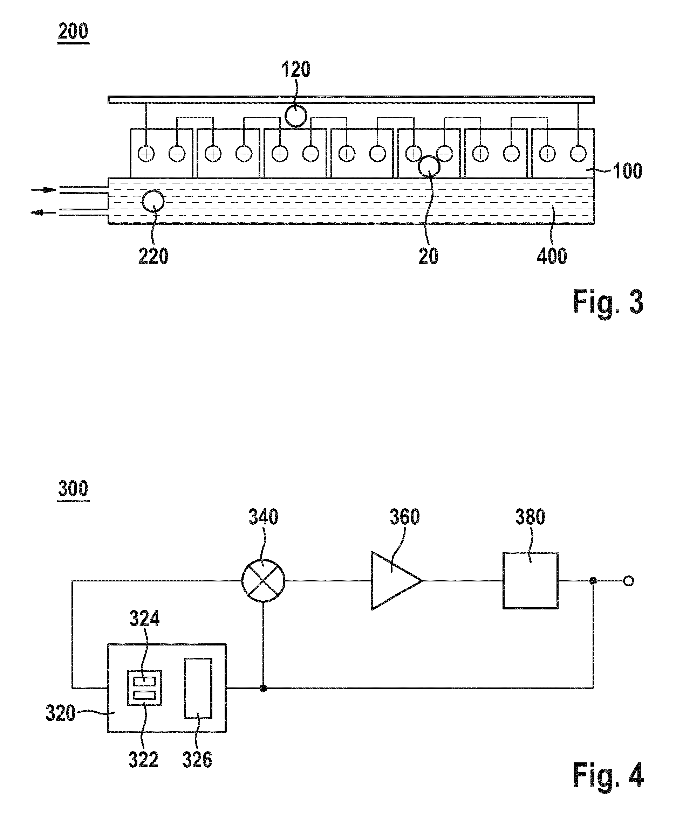

Figur 3 zeigt ferner eine erfindungsgemäße Batterie 200 in einer weiteren Ausgestaltung mit mehreren Batteriezellen 100, bei der die Batteriezellen 100 beispielhaft von unten mittels einer Kühlung 400, bevorzugt einer Wasserkühlung 400, gekühlt werden. In der Kühlung 400 befindet sich ein dritter Temperatursensor 220, der bevorzugt ebenfalls ein Temperaturfühler wie der erste Temperatursensor 120 ist.

Die Temperaturen des zweiten Temperaturfühlers können erfindungsgemäß zur Erhöhung der Sicherheit der Batterie 200 beitragen.

Dabei ist die absolute Genauigkeit des zweiten Temperatursensors 20 nachrangig, entscheidend ist eine hohe Dynamik bei der Erfassung von Temperaturwechseln über die Zeit. Mit anderen Worten weist der zweite Temperatursensor 20 eine höhere Dynamik als der erste und/oder der dritte Temperatursensor 120, 220 auf. Er reagiert schneller auf Temperaturwechsel als die beiden äußeren Temperatursensoren 120, 220.

Bevorzugt ist die absolute Temperaturgenauigkeit des zweiten Temperatursensors 20 geringer als die Genauigkeit des ersten und dritten Temperatursensors 120, 220. Dadurch kann der zweite Temperatursensor 20 kostengünstiger ausgebildet sein.

Ist der zweite Temperatursensor 20 in jeder Batteriezelle 100 integriert, ist die Erhöhung der Sicherheit am größten. So kann ein starker Temperaturanstieg jeder Batteriezelle 100 sofort registriert werden. Ab einer gewissen Schwelle für ΔT₂/dt öffnet die Batterietrenneinheit 90 Batterieschütze und trennt die Batterie 200 von einem externen Stromkreis ab. Dies kann bevorzugt ebenso geschehen, wenn eine Absolutwertschwelle der Temperatur T₂ überschritten wird.

Ist der zweite Temperatursensor 20 nicht in jeder Batteriezelle 100 integriert, so registriert er kritische Temperaturanstiege in benachbarten Zellen 100 dennoch schneller als die herkömmliche Temperaturüberwachung, da die Temperaturen ja im Zellkern 10 am höchsten sind und so auch schneller auf die Zellkerne 10 als auf die Gehäuse 70 bzw. Terminals 60, 62 übertragen werden.

Nach einer längeren Ruhephase der Batterie 200, im thermischen Gleichgewicht kann die zweite und/oder die dritte Temperatur des ersten bzw. dritten Temperatursensors zum Abgleich der Temperatur des zweiten Temperatursensors 20 verwendet werden. Beispielsweise kann dann T₂=T₁ bzw. T₂=T₁=T₃ gesetzt werden.

Vorteilhafterweise kann so eine niedrigere absolute Genauigkeit des zweiten Temperatursensors 20 ausgeglichen werden, indem die Temperatur T₂ des zweiten Temperatursensors 20 mithilfe der absolut genaueren ersten und/oder dritten Temperatursensoren 120, 220 kalibriert wird.

Das erfindungsgemäße Batteriesteuergerät 40 ist dazu eingerichtet, die Kalibrierung und/oder die Abtrennung der Batterie 200 mittels des zweiten Temperatursensors 20 bei einer Schwellwertüberschreitung von T2 oder ΔT₂/dt durchzuführen.

Ferner können auch die Änderungswerte ΔT₁/dt und/oder ΔT₃/dt redundant für die Erhöhung der Sicherheit eingesetzt werden. So können die Temperaturveränderungen ΔT₁/dt und ΔT₃/dt des ersten und/oder dritten Temperatursensors 120, 220 zur Bewertung des Temperaturanstiegs in der Batteriezelle 100 eingesetzt werden. Damit können die Temperaturmesswerte T1, T2, T3 und die zugehörigen ΔT/dt gegenseitig plausibilisiert werden, wodurch die Betriebssicherheit erhöht werden kann. Zum anderen kann mit höherer Genauigkeit auf die Zellkerntemperatur von Zellen geschlossen werden, welche keinen integrierten Temperaturfühler aufweisen.

Figur 4 zeigt ein Ausführungsbeispiel eines thermischen Oszillators 300, der in der Erfindung Einsatz findet. Der thermische Oszillator 300 umfasst einen elektrothermischen Filter 320 mit einem Heizelement 326 und einer Thermosäule 322, die verschiedene Thermoelemente 324 aufweist. Die Thermoelemente 322 sind dabei als Dünnschichtstrukturen ausgeführt. Sie können beispielsweise p+ Diffusions/Aluminium-Thermoelemente 324 sein. Der Vorteil von Thermoelementen 324 gegenüber Transistoren oder Widerständen ist, dass sie keinen Offset aufweisen und frei von 1/f-Rauschen sind. Ferner umfasst der thermische Oszillator einen Multiplizierer 340, einen Integrator 360 und einen spannungsgesteuerten Oszillator 380. Die Thermosäule 320, das Heizelement 326 und der spannungsgesteuerte Oszillator 380 sind über eine Feedbackschleife mit dem Multiplizierer verbunden. Der Phasenversatz des elektrothermischen Filters 320 bestimmt infolgedessen die Frequenz des spannungsgesteuerten Oszillators 380. Der Phasenversatz des elektrothermischen Filters 320 entsteht durch die Verzögerung zwischen der Erzeugung eines thermischen Pulses (kurzzeitige Temperaturerhöhung) am Heizelement 326 und der Erkennung, bzw. Rückumwandlung in einen Spannungspuls an der Thermosäule 322. Diese Phasenverschiebung ist von der Grundtemperatur des Substrates abhängig, auf welchem der thermische Oszillator aufgebaut ist, welches wiederum die Temperatur der Umgebung annimmt. Dadurch wird die Schwingfrequenz des thermischen Oszillators 300 abhängig von der Temperatur der Batteriezelle 100.

## Patentansprüche

1. Batterie (200) umfassend mindestens eine Batteriezelle (100) mit einem Gehäuse (70), in dem eine Elektrodenanordnung (10) angeordnet ist, einem ersten Temperatursensor (120), der außerhalb des Batteriezellgehäuses (70) angeordnet ist, einem zweiten Temperatursensor (20), der im Inneren des Batteriezellgehäuses (70) angeordnet ist, **dadurch gekennzeichnet, dass** die Temperaturdynamik (ΔT/dt) des zweiten Temperatursensors (20) höher ist als die Temperaturdynamik des ersten Temperatursensors (120), wobei Ausgangssignale des zweiten Temperatursensors (20) mittels Stromsammler (30) der Elektrodenanordnung (10) über Terminals (60, 62) aus der Batteriezelle (100) herausgeführt werden.

2. Batterie (200) nach Anspruch 1, umfassend mehrere in Reihe angeordnete Batteriezellen (100), wobei mehrere der Batteriezellen (100) einen ersten Temperatursensor (120), der außerhalb der Batteriezellen (100) angeordnet ist, aufweisen und mindestens eine der Batteriezellen (100) einen zweiten Temperatursensor (20) aufweist, der im Inneren des Gehäuses (70) der betreffenden Batteriezelle (100) angeordnet ist.

3. Batterie (200) nach Anspruch 1 oder 2, wobei der zweite Temperatursensor (20) einen elektrothermischen Oszillator (300), der eine Temperatur in eine Frequenz umwandelt, umfasst, bevorzugt einen Differentialtemperatursensor.

4. Batteriezelle (100) nach Anspruch 3, wobei der zweite Temperatursensor (20) eine Temperaturdynamik (ΔT/dt) zwischen 0,5 K/min und 5 K/min aufweist.

5. Batteriezelle (100) nach einem der vorhergehenden Ansprüche, wobei der zweite Temperatursensor (20) in einer integrierten Schaltung in einem Mikrochip integriert ist.

6. Batterie (200) nach einem der vorhergehenden Ansprüche, wobei der erste Temperatursensor (120) ein Temperaturfühler ist.

7. Batterie (200) nach einem der vorhergehenden Ansprüche, ferner umfassend ein Batteriesteuergerät (40), welches dazu eingerichtet ist, die Temperaturen der ersten und zweiten Temperatursensoren (120, 20) zu empfangen und zu verarbeiten, und eine Batterietrenneinheit (90), die dazu eingerichtet ist, bei Überschreiten eines Schwellenwertes der Temperaturdynamik (ΔT₂/dt) des zweiten Temperatursensors (20) und/oder bei Überschreiten des Temperaturwertes (T₂) des zweiten Temperatursensors (20) die Batterie (200) von der Stromversorgung zu trennen.

8. Batterie (200) nach Anspruch 7, wobei ferner das Batteriesteuergerät (40) dazu eingerichtet ist, den zweiten Temperatursensor (20) bei thermischem Gleichgewicht mittels des ersten Temperatursensors (120) zu kalibrieren.

9. Batterie (200) nach einem der vorhergehenden Ansprüche, wobei ferner ein dritter Temperatursensor (220) in einer Kühlung (400) der Batteriezellen (100) in der Batterie (200) angeordnet ist.

10. Kraftfahrzeug mit einer Batterie (200) nach einem der vorhergehenden Ansprüche, wobei die Batterie (200) mit dem Antrieb des Kraftfahrzeuges verbunden ist.

11. Verfahren zum Betrieb einer Batterie (200) nach Anspruch 1 bis 9, umfassend die Schritte:
Bestimmen der Temperatur außerhalb der Batteriezellen (100) durch den mindestens einen ersten Temperatursensor (120),
Bestimmen der Änderung des Temperaturanstiegs (ΔT₂/dt) des zweiten Temperatursensors (20), und
Trennen der Batterie (200) von einem angeschlossenen Stromkreis bei Überschreiten eines Schwellwertes des Temperaturanstiegs (ΔT₂/dt) des zweiten Temperatursensors (20), und/oder bei Überschreiten eines Schwellwertes der Temperatur (T₂) des zweiten Temperatursensors (20).

12. Verfahren zum Betrieb einer Batterie (200) nach Anspruch 11, ferner umfassend die Schritte:
in Ruhephase der Batterie (200), Bestimmung der Temperaturen des ersten Temperatursensors (120) und des zweiten Temperatursensors (20); und
bei Abweichen der Temperaturwerte, Kalibrierung des zweiten Temperatursensors (20) mithilfe der Temperatur des ersten Temperatursensors (120).

## Claims

1. Battery (200) comprising at least one battery cell (100) having a housing (70), in which an electrode arrangement (10) is arranged, a first temperature sensor (120), which is arranged outside the battery cell housing (70), a second temperature sensor (20), which is arranged in the interior of the battery cell housing (70), **characterized in that** the temperature dynamic range (ΔT/dt) of the second temperature sensor (20) is higher than the temperature dynamic range of the first temperature sensor (120), wherein output signals of the second temperature sensor (20) are passed out of the battery cell (100) by means of current collectors (30) of the electrode arrangement (10).

2. Battery (200) according to Claim 1, comprising a plurality of battery cells (100) arranged in series, wherein a plurality of the battery cells (100) have a first temperature sensor (120) arranged outside the battery cells (100), and at least one of the battery cells (100) has a second temperature sensor (20) arranged in the interior of the housing (70) of the relevant battery cell (100).

3. Battery (200) according to Claim 1 or 2, wherein the second temperature sensor (20) comprises an electrothermal oscillator (300) that converts a temperature into a frequency, preferably a differential temperature sensor.

4. Battery cell (100) according to Claim 3, wherein the second temperature sensor (20) has a temperature dynamic range (ΔT/dt) of between 0.5 K/min and 5 K/min.

5. Battery cell (100) according to any of the preceding claims, wherein the second temperature sensor (20) is integrated in an integrated circuit in a microchip.

6. Battery (200) according to any of the preceding claims, wherein the first temperature sensor (120) is a temperature detector.

7. Battery (200) according to any of the preceding claims, furthermore comprising a battery control unit (40) designed to receive and process the temperatures of the first and second temperature sensors (120, 20), and a battery isolating unit (90) designed to isolate the battery (200) from the power supply when a threshold value of the temperature dynamic range (ΔT₂/dt) of the second temperature sensor (20) is exceeded and/or when the temperature value (T₂) of the second temperature sensor (20) is exceeded.

8. Battery (200) according to Claim 7, wherein the battery control unit (40) is furthermore designed to calibrate the second temperature sensor (20) upon thermal equilibrium by means of the first temperature sensor (120).

9. Battery (200) according to any of the preceding claims, wherein a third temperature sensor (220) is furthermore arranged in a cooling system (400) of the battery cells (100) in the battery (200).

10. Motor vehicle comprising a battery (200) according to any of the preceding claims, wherein the battery (200) is connected to the drive of the motor vehicle.

11. Method for operating a battery (200) according to Claims 1 to 9, comprising the following steps:
determining the temperature outside the battery cells (100) by means of the at least one first temperature sensor (120),
determining the change in the temperature rise (ΔT₂/dt) of the second temperature sensor (20), and
isolating the battery (200) from a connected electrical circuit when a threshold value of the temperature rise (ΔT₂/dt) of the second temperature sensor (20) is exceeded, and/or when a threshold value of the temperature (T₂) of the second temperature sensor (20) is exceeded.

12. Method for operating a battery (200) according to Claim 11, furthermore comprising the following steps:
in the quiescent phase of the battery (200), determining the temperatures of the first temperature sensor (120) and of the second temperature sensor (20); and in the case of deviation of the temperature values, calibrating the second temperature sensor (20) with the aid of the temperature of the first temperature sensor (120).

## Revendications

1. Batterie (200) comprenant au moins un élément de batterie (100) avec un boîtier (70) dans lequel un agencement d'électrodes (10) est disposé, un premier capteur de température (120) qui est disposé en-dehors du boîtier de l'élément de batterie (70), un deuxième capteur de température (20) qui est disposé à l'intérieur du boîtier de l'élément de batterie (70), **caractérisée en ce que** la dynamique de température (ΔT/dt) du deuxième capteur de température (20) est supérieure à la dynamique de température du premier capteur de température (120), dans lequel des signaux de sortie du deuxième capteur de température (20) sont guidés hors de l'élément de batterie (100), via des bornes (60, 62), au moyen de collecteurs de courant (30) de l'agencement d'électrodes (10).

2. Batterie (200) selon la revendication 1, comprenant plusieurs éléments de batterie (100) disposés en rangée, dans laquelle plusieurs des éléments de batterie (100) présentent un premier capteur de température (120) qui est disposé en-dehors des éléments de batterie (100) et au moins l'un des éléments de batterie (100) présentant un deuxième capteur de température (20), lequel est disposé à l'intérieur du boîtier (70) de l'élément de batterie (100) concerné.

3. Batterie (200) selon la revendication 1 ou 2, dans laquelle le deuxième capteur de température (20) comprend un oscillateur électrothermique (300) qui transforme une température en une fréquence, de préférence un capteur de température différentiel.

4. Elément de batterie (100) selon la revendication 3, dans lequel le deuxième capteur de température (20) présente une dynamique de température (ΔT/dt) comprise entre 0,5 k/min et 5 k/min.

5. Elément de batterie (100) selon l'une des revendications précédentes, dans lequel le deuxième capteur de température (20) est intégré dans un circuit intégré dans une micro-puce.

6. Batterie (200) selon l'une des revendications précédentes, dans laquelle le premier capteur de température (120) est une sonde de température.

7. Batterie (200) selon l'une des revendications précédentes, comprenant par ailleurs un appareil de commande de batterie (40) qui est étudié pour réceptionner et traiter les températures des premier et deuxième capteurs de température (120, 20), et une unité de coupure de batterie (90) qui est étudiée, en cas de dépassement par le haut d'une valeur de seuil de la dynamique de température (ΔT₂/dt) du deuxième capteur de température (20) et/ou de dépassement par le haut de la valeur de température (T₂) du deuxième capteur de température (20), pour couper la batterie (200) de l'alimentation en courant.

8. Batterie (200) selon la revendication 7, dans laquelle l'appareil de commande de batterie (40) est en outre étudié pour étalonner le deuxième capteur de température (20), en cas d'équilibre thermique, au moyen du premier capteur de température (120).

9. Batterie (200) selon l'une des revendications précédentes, dans laquelle un troisième capteur de température (220) est en outre disposé dans un refroidisseur (400) des éléments de batterie (100) dans la batterie (200).

10. Véhicule automobile avec une batterie (200) selon l'une des revendications précédentes, dans lequel la batterie (200) est en liaison avec un dispositif d'entraînement du véhicule automobile.

11. Procédé pour faire fonctionner une batterie (200) selon les revendications 1 à 9, comprenant les étapes suivantes :
la détermination de la température en-dehors des éléments de batterie (100) grâce à l'au moins un premier capteur de température (120),
la détermination de la variation de la hausse de température (ΔT₂/dt) du deuxième capteur de température (20), et
la coupure de la batterie (200) d'un circuit électrique raccordé en cas de dépassement par le haut d'une valeur de seuil de hausse de température (ΔT₂/dt) du deuxième capteur de température (20) et/ou en cas de dépassement par le haut d'une valeur de seuil de la température (T₂) du deuxième capteur de température (20).

12. Procédé pour faire fonctionner une batterie (200) selon la revendication 11, comprenant par ailleurs les étapes suivantes :
lors de la phase de repos de la batterie (200), la détermination des températures du premier capteur de température (120) et du deuxième capteur de température (20) ; et en cas de divergence des valeurs de température, l'étalonnage du deuxième capteur de température (20) à l'aide de la température du premier capteur de température (120).
